(19) **Europäisches Patentamt**
**European Patent Office**
**Office européen des brevets**

(11) **EP 1 466 329 B1**

(12) **FASCICULE DE BREVET EUROPEEN**

(45) Date de publication et mention
de la délivrance du brevet:
**11.04.2007 Bulletin 2007/15**

(21) Numéro de dépôt: **02796844.5**

(22) Date de dépôt: **14.11.2002**

(51) Int Cl.:
***G11C 11/16*** *(2006.01)*

(86) Numéro de dépôt international:
**PCT/FR2002/003896**

(87) Numéro de publication internationale:
**WO 2003/043017 (22.05.2003 Gazette 2003/21)**

(54) **DISPOSITIF MAGNETIQUE A JONCTION TUNNEL MAGNETIQUE, MEMOIRE ET PROCEDES D'ECRITURE ET DE LECTURE UTILISANT CE DISPOSITIF**

MAGNETISCHE TUNNELÜBERGANGSEINRICHTUNG, SPEICHER UND SCHREIBE- UND LESE-VERFAHREN UNTER VERWENDUNG EINER SOLCHEN

MAGNETIC DEVICE WITH MAGNETIC TUNNEL JUNCTION, MEMORY ARRAY AND READ/WRITE METHODS USING SAME

(84) Etats contractants désignés:
**AT BE BG CH CY CZ DE DK EE ES FI FR GB GR IE IT LI LU MC NL PT SE SK TR**

(30) Priorité: **16.11.2001 FR 0114840**

(43) Date de publication de la demande:
**13.10.2004 Bulletin 2004/42**

(73) Titulaire: **COMMISSARIAT A L'ENERGIE ATOMIQUE**
**75015 Paris (FR)**

(72) Inventeurs:
• **DIENY, Bernard**
**F-38250 Lans-en-Vercors (FR)**

• **REDON, Olivier**
**F-38170 Seyssinet Pariset (FR)**

(74) Mandataire: **Lewitter, Herbert**
**Santarelli**
**14 avenue de la Grande-Armée**
**B.P. 237**
**75822 Paris Cedex 17 (FR)**

(56) Documents cités:
**WO-A-00/79540         US-A1- 2001 019 461**
**US-B1- 6 272 036       US-B1- 6 385 082**

**Description**

**DOMAINE TECHNIQUE**

La présente invention concerne un dispositif magnétique à jonction tunnel ainsi qu'une mémoire utilisant ce dispositif.

L'invention concerne aussi un procédé d'écriture thermomagnétique dans ce dispositif ainsi qu'un procédé de lecture du dispositif.

L'invention trouve une application en électronique et notamment dans la réalisation de points mémoires et de mémoires de type MRAM ("Magnetic Random Access Memory" ou mémoire magnétique à accès direct (ou aléatoire)).

**ETAT DE LA TECHNIQUE ANTÉRIEURE**

Les mémoires magnétiques MRAM ont connu un regain d'intérêt avec la mise au point de jonctions tunnel magnétiques (en abrégé MTJ pour "Magnetic Tunnel Junction") présentant une forte magnétorésistance à température ambiante.

Au sujet des mémoires magnétiques utilisant des jonctions tunnel magnétiques, on consultera par exemple les documents suivants:

[1] US 5 640 343 A (Gallagher et al.)
[2] S.S.P. Parkin et al., J.Appl.Phys., vol.85 n°8,1999, pp.5828-5833.

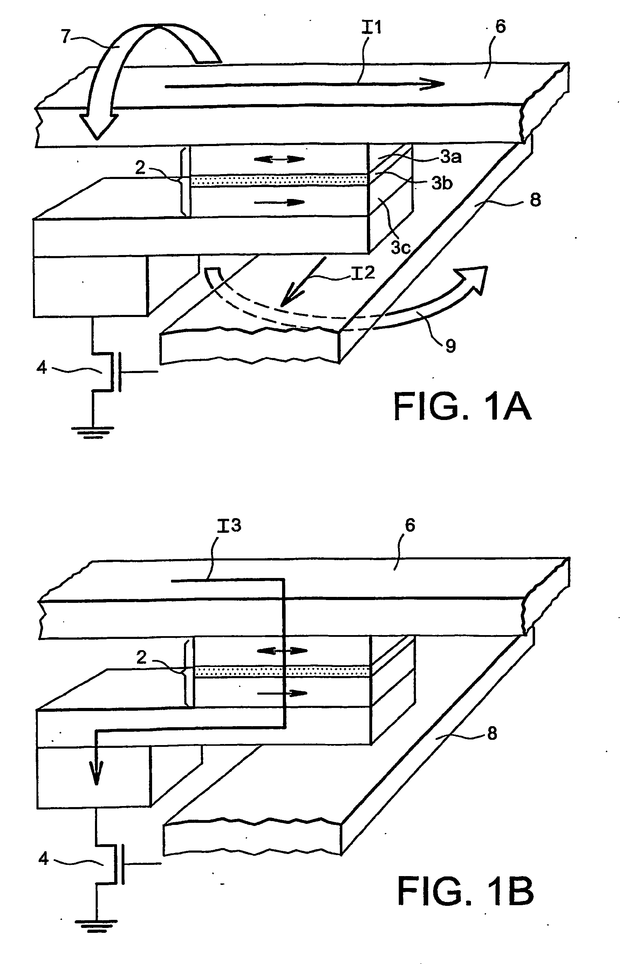

Les figures 1A et 1B annexées illustrent schématiquement la structure et la fonction d'une jonction tunnel magnétique connue.

La jonction porte la référence 2. Il s'agit d'un empilement comprenant une couche d'oxyde 3b en sandwich entre deux couches magnétiques. Ce système fonctionne comme une vanne de spin, à la différence que le courant circule perpendiculairement aux plans des couches.

L'une 3a des couches magnétiques est dite "libre" ou "de stockage" car on peut orienter son aimantation dans la direction désirée à l'aide d'un champ magnétique extérieur (flèche bidirectionnelle) ; l'autre couche magnétique 3c est dite "piégée" ou "de référence" car sa direction d'aimantation est fixée par couplage d'échange avec une couche antiferromagnétique (flèche unidirectionnelle).

Lorsque les aimantations des couches magnétiques sont antiparallèles, la résistance de la jonction est élevée ; lorsque les aimantations sont parallèles, cette résistance devient faible. La variation relative de résistance entre ces deux états peut atteindre 40% par un choix approprié des matériaux des couches de l'empilement et/ou de traitements thermiques de ces matériaux.

La jonction 2 est placée entre un transistor de commutation 4 et une ligne d'amenée de courant 6 formant une ligne conductrice supérieure. Un courant I1 passant dans celle-ci produit un premier champ magnétique 7. Un conducteur 8 formant une ligne conductrice inférieure, orthogonale à la ligne d'amenée de courant 6 permet, en y faisant circuler un courant I2, de produire un second champ magnétique 9.

Dans le mode "écriture" (figure 1A), le transistor 4 est placé en mode bloqué et aucun courant ne traverse donc ce transistor. On fait circuler des impulsions de courant dans la ligne d'amenée de courant 6 et dans le conducteur 8. La jonction 2 est donc soumise à deux champs magnétiques orthogonaux. L'un est appliqué selon l'axe de difficile aimantation de la couche libre 3a, afin de réduire son champ de retournement, tandis que l'autre est appliqué selon son axe facile afin de provoquer le retournement de l'aimantation et donc l'écriture du point mémoire.

Dans le principe, seul le point mémoire placé à l'intersection des deux lignes 6 et 8 est susceptible de se retourner, car chaque champ magnétique pris individuellement n'est pas suffisamment grand pour provoquer un basculement de l'aimantation.

Dans le mode "lecture" (figure 1B), le transistor est placé en régime saturé (c'est-à-dire que le courant traversant ce transistor est maximum) par l'envoi d'une impulsion de courant positive dans la grille du transistor. Le courant I3 envoyé dans la ligne 6 traverse uniquement le point mémoire dont le transistor est placé en mode saturé.

Ce courant permet de mesurer la résistance de la jonction de ce point mémoire. Par comparaison avec un point mémoire de référence, l'état du point mémoire ("O" ou "1") peut ainsi être déterminé : on sait alors si l'aimantation de la couche de stockage 3a est parallèle au antiparallèle à celle de la couche de référence 3c.

Un tel mécanisme d'écriture présente des inconvénients en particulier dans un réseau de jonctions tunnel:

1) Comme le renversement de l'aimantation de la couche libre d'une jonction se produit sous l'effet de champs extérieurs et comme les champs de retournement sont statistiquement distribués, il n'est pas impossible de retourner accidentellement certaines jonctions voisines simplement par l'effet du champ magnétique produit le long d'une ligne conductrice inférieure ou supérieure. Comme, pour des mémoires à haute densité, la taille des points mémoires est nettement submicronique, le nombre d'erreurs d'adressage augmente.

2) La diminution de la taille des points mémoires entraîne une augmentation de la valeur du champ de retournement individuel ; un courant plus important est alors nécessaire pour écrire les points mémoires, ce qui tend à augmenter la consommation électrique.

3) Le mode d'écriture utilise deux lignes de courant à 90°, ce qui limite la densité d'intégration.

WO 00 79540 est considéré comme l'état de la technique le plus proche, et décrit avec sa figure 1A un dispositif comprenant une jonction tunnel magnétique qui comporte une premiere couche magnetique couplée à une couche antiferromagnétique, une deuxième couche magnétique et une troisième couche électriquement isolante qui sépare les deux premieres couches. L'effet de la couche antiferromagnétique est de rendre la premiere couche plus dure que la deuxième couche magnétique. Ce dispositif comporte en outre des moyens d'échauffement de la jonction, ces moyens étant en autre des moyens prévus pour faire circuler un courant d'électrons à travers la jonction tunnel magnétique et des moyens d'application d'un champ magnétique apte à orienter l'aimantation dans la cellule .

Cependant selon ce document, la temperature d'échauffement visée est supérieure à la temperature de blocage de l'aimantation de la couche antiferromagnétique et force ainsi la couche magnetique la plus dure à se re-orienter selon le champ magnétique impose.

Ce même document propose aussi un dispositif sans couche antiferromagnétique mais toujours composé d'une premiere couche magnétique plus dure que la deuxième couche magnétique. La temperature visée lors de l'échauffement est alors supérieure à la temperature de Curie des matériaux ferromagnétiques. Dans les deux cas exposés, la premiere couche magnétique magnétiquement plus dure voit ainsi son orientation magnétique changer, tout comme la deuxième couche.

## EXPOSE DE L'INVENTION

La présente invention a pour but de remédier aux inconvénients précédents.

Selon un aspect de la présente invention, on propose un dispositif magnétique à jonction tunnel magnétique qui est utilisable dans une MRAM et dans lequel le mécanisme d'écriture est insensible à la distribution des champs de retournement pour éliminer les erreurs d'adressage et obtenir une bonne reproductibilité de l'écriture des informations.

Selon un autre aspect de l'invention, on propose un dispositif magnétique à jonction tunnel magnétique dont la consommation en énergie est faible.

Selon encore un autre aspect, on propose un dispositif magnétique à jonction tunnel magnétique permettant un stockage multi-niveaux d'informations. Cela présente l'avantage, dans une mémoire conforme à l'invention, d'accroître la capacité de stockage pour un même nombre de points mémoires.

La présente invention a également pour but d'améliorer les mémoires magnétiques en diminuant la taille de leurs points mémoires, tout en gardant l'information stable à température ambiante, ainsi que le taux d'erreur d'écriture de ces mémoires.

Dans l'invention, on utilise une propriété connue d'un matériau magnétique, selon laquelle le champ de retournement de l'aimantation, c'est-à-dire le champ nécessaire au retournement de l'aimantation est très faible lorsqu'on élève la température de ce matériau au-delà de la température de blocage de l'aimantation de ce matériau.

De façon précise, la présente invention a pour objet un dispositif magnétique comprenant une jonction tunnel magnétique qui comporte :

- une première couche magnétique formant une couche de référence et ayant une aimantation de direction fixe,
- une deuxième couche magnétique formant une couche de stockage et ayant une aimantation de direction variable, et
- une troisième couche qui est semiconductrice ou électriquement isolante et qui sépare la première couche de la deuxième couche,

ce dispositif étant caractérisé en ce que la température de blocage de l'aimantation de la couche de stockage est inférieure à la température de blocage de l'aimantation de la couche de référence et en ce que le dispositif comprend en outre :

- des moyens d'échauffement de la couche de stockage à une température supérieure à la température de blocage de l'aimantation de cette couche de stockage, les moyens d'échauffement de la couche de stockage étant des moyens prévus pour faire circuler un courant d'électrons à travers la jonction tunnel magnétique, et
- des moyens d'application, a cette couche de stockage, d'un champ magnétique et/ou d'un couple magnétique apte à orienter l'aimantation de cette couche de stockage par rapport à l'aimantation de la couche référence, sans modifier l'orientation de cette couche de référence.

Selon un mode de réalisation préféré de l'invention, les températures de blocage des couches de stockage et de référence ont des valeurs supérieures à la valeur de la température de fonctionnement du dispositif hors échauffement de la jonction tunnel (on sait que le dispositif s'échauffe lorsqu'il fonctionne).

Selon un premier mode de réalisation particulier du dispositif objet de l'invention, l'aimantation de chacune des couches de stockage et de référence est sensiblement perpendiculaire au plan de ces couches.

Dans ce cas, la couche de stockage peut être une monocouche en alliage Co-Pt ou Co-Pd ou une multicouche formée par un empilement de couches de Co alternant avec des couches de Pt ou de Pd de façon que le champ coercitif de la couche de stockage diminue rapidement quand la température augmente.

En variante, la couche de stockage peut être une monocouche en alliage riche en cobalt avec du fer ou du nickel ou du chrome ainsi que du platine ou du palladium, ou une multicouche formée par un empilement de couches d'un alliage riche en cobalt avec du fer ou du nickel ou du chrome, alternant avec des couches de Pt ou de Pd de façon que le champ coercitif de la couche de stockage diminue rapidement quand la température augmente.

Selon un deuxième mode de réalisation particulier, l'aimantation de chacune des couches de stockage et de référence est sensiblement parallèle au plan de ces couches.

Le dispositif objet de l'invention peut comprendre en outre une première couche antiferromagnétique associée à la couche de référence.

De préférence, la température de blocage de l'aimantation de cette première couche antiferromagnétique est supérieure à la température de blocage de la couche de stockage.

Selon un mode de réalisation particulier de l'invention, la couche de référence est une multicouche comprenant deux couches magnétiques et une couche intermédiaire en Ru ou en Re ou en Ir ou en Rh, les deux couches magnétiques étant séparées par la couche intermédiaire et couplées de façon antiparallèle par interaction à travers cette couche intermédiaire.

Selon un mode de réalisation préféré du dispositif objet de l'invention, ce dispositif comprend en outre une deuxième couche antiferromagnétique couplée à la couche de stockage par anisotropie d'échange.

De préférence, la température de blocage de l'aimantation de cette deuxième couche antiferromagnétique est inférieure à la température de blocage de la couche de référence.

Les moyens d'application du couple magnétique à la couche de stockage sont constitués par des moyens d'injection, dans cette couche de stockage d'un courant d'électrons dont le spin est polarisé.

La présente invention concerne aussi une mémoire comprenant une matrice de points mémoires adressables par des lignes et des colonnes d'adressage, cette mémoire étant caractérisée en ce que chaque point mémoire comprend :

- un dispositif magnétique conforme à l'invention, et
- un moyen de commutation de courant placé en série avec ce dispositif magnétique,

chaque dispositif magnétique étant relié à une ligne d'adressage et chaque moyen de commutation étant relié à une colonne d'adressage.

La présente invention concerne également un procédé d'écriture d'une information dans un dispositif magnétique conforme à l'invention, dans lequel:

- on chauffe la couche de stockage à une température supérieure à la température de blocage de l'aimantation de cette couche de stockage et
- pendant le refroidissement de la couche de stockage, on applique à cette couche de stockage un champ et/ou un couple magnétique apte à orienter l'aimantation de cette couche de stockage par rapport à l'aimantation de la couche de référence, sans modifier l'orientation de cette couche de référence.

De préférence la valeur, vue par la couche de référence, du champ magnétique appliqué au cours du de l'écriture, est inférieure à la valeur du champ et/ou du couple magnétique nécessaire au retournement de l'aimantation de la couche de référence à la température maximale atteinte par cette couche au cours de l'échauffement de la jonction.

Selon un mode de mise en oeuvre préféré du procédé d'écriture objet de l'invention, la couche de stockage est couplée à une couche antiferromagnétique par anisotropie d'échange et l'on chauffe la couche de stockage et cette couche antiferromagnétique à une température supérieure à la température de blocage de l'aimantation de ces couches et, au cours du refroidissement de la couche antiferromagnétique, on oriente l'aimantation de la couche de stockage dans une direction quelconque prédéfinie par la direction d'aimantation d'un champ magnétique appliqué pendant le refroidissement.

La présente invention concerne en outre un procédé de lecture d'une information mémorisée dans un dispositif conforme à l'invention, dans lequel

- on détermine la valeur de la résistance de la jonction tunnel magnétique, et
- on déduit l'orientation de l'aimantation de la couche de stockage à partir de cette valeur de la résistance.

## BREVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- les figures 1A et 1B illustrent schématiquement le principe de fonctionnement d'un dispositif magnétique connu, à jonction tunnel, et ont déjà été décrites,
- la figure 2 est une vue schématique et partielle d'une mémoire comprenant une matrice de dispositifs magnétiques à jonction tunnel
- la figure 3 illustre schématiquement le principe de fonctionnement d'un dispositif magnétique à jonction tunnel conforme à l'invention,
- la figure 4 est une vue en coupe schématique d'un exemple de jonction tunnel qui est utilisable dans la présente invention et dont des couches ont une aimantation perpendiculaire au plan de ces couches,
- la figure 5 est un graphique illustrant l'obtention de deux champs coercitifs différents en couplant à un matériau antiferromagnétique l'une des deux couches d'une jonction tunnel utilisable dans l'invention,
- la figure 6 est un graphique montrant les variations du champ de retournement en fonction de la température pour des multicouches utilisables dans l'invention,
- la figure 7 illustre schématiquement un exemple d'un ensemble de dispositifs magnétiques conformes à l'invention, utilisant des jonctions tunnel à aimantation perpendiculaire au plan de leurs couches,
- la figure 8 illustre schématiquement un exemple de dispositif magnétique conforme à l'invention, utilisant la combinaison d'un échauffement par effet Joule et d'une commutation magnétique par injection d'un courant d'électrons dont le spin est polarisé,
- la figure 9 est une vue en coupe schématique d'un exemple de jonction tunnel qui est utilisable dans l'invention et a une aimantation planaire.
- la figure 10 est une vue schématique d'un exemple de dispositif magnétique conforme à l'invention, utilisant une jonction tunnel à aimantation planaire, et
- la figure 11 est une vue schématique d'un autre exemple d'un tel dispositif.

## EXPOSE DETAILLE DE MODES DE REALISATION PARTICULIERS

Dans un exemple de la présente invention, une mémoire magnétique comprend une matrice de dispositifs magnétiques conformes à l'invention. Chacun de ces dispositifs, également appelés "points mémoires", comprend une jonction tunnel magnétique de la forme F1/O/F2 où F1 et F2 désignent respectivement la couche magnétique de stockage, également appelée "électrode magnétique de stockage", et la couche magnétique de référence, également appelée "électrode magnétique de référence", et O désigne la couche qui est comprise entre F1 et F2 et forme une barrière tunnel.
Chacune des couches F1 et F2 est caractérisée par un champ de retournement de son aimantation, champ qui est fonction de la température du matériau constituant cette couche.
Dans la présente invention, les matériaux des couches F1 et F2 sont choisis de sorte que la décroissance en température du champ de retournement de la couche F1, noté HcF1, soit beaucoup plus rapide que celle du champ de retournement de la couche F2, noté HcF2.
Typiquement, on choisit les matériaux des couches F1 et F2 de sorte que leurs champs de retournement soient, à température ambiante (environ 20°C), de l'ordre de 100 Oe (environ 8000 A/m) pour F1 (on rappelle que 1 Oe vaut 1000/(4π) A/m) et de l'ordre de 600 Oe (environ 48000 A/m) pour F2 et, à 200°C, de l'ordre de 5 Oe (environ 400 A/m) pour F1 et 400 Oe (environ 32000 A/m) pour F2.
En d'autres termes, on choisit les matériaux des couches F1 et F2 de sorte que la température de blocage de l'aimantation de la couche F1, également appelée "température de blocage magnétique" de la couche F1 ou, plus simplement, "température de blocage" de la couche F1, soit significativement plus faible que la température de blocage de l'aimantation de la couche F2.
Lors de l'écriture, le principe de la sélection d'un point mémoire consiste alors à provoquer un très bref échauffement (jusqu'à une température Tmax, typiquement jusqu'à 200°C) de ce point mémoire, échauffement qui a pour effet d'abaisser le champ de retournement de l'aimantation de la couche magnétique F1 dans laquelle l'information est stockée.
Le principe de fonctionnement du dispositif étant basé sur des variations de température, il semble évident que les couches de stockage et de référence doivent de préférence avoir des températures de blocage supérieures à la température de fonctionnement du dispositif hors échauffement.
De plus, le but de ce dispositif étant de stocker de l'information de façon stable, il est donc, aussi pour cette raison, préférable que ces couches aient des températures de blocage nettement supérieures à la température de fonctionnement du dispositif.

Pendant le refroidissement du point mémoire, un champ magnétique d'amplitude He tel que

$$HcF1(Tmax) < He < HcF2(Tmax),$$

He étant ainsi typiquement compris entre environ 20 Oe et 60 Oe (environ 1600A/m et 4800A/m), est appliqué dans la direction dans laquelle on souhaite orienter l'aimantation de la couche de stockage F1.

L'aimantation de cette couche de stockage F1 s'oriente alors dans la direction du champ appliqué He alors que celle de la couche de référence F2, également appelée "couche piégée", reste toujours orientée dans la même direction.

L'échauffement de la jonction peut être contrôlé par l'envoi d'une brave impulsion de courant (de l'ordre de $10^4$A/cm$^2$ à $10^5$A/cm$^2$ pendant quelques nanosecondes) au travers de la jonction.

Le champ magnétique He est créé par l'envoi d'impulsions de courant dans des lignes conductrices situées dans des plans se trouvant au dessus et/ou au dessous des jonctions tunnel magnétiques.

Une deuxième possibilité pour faire commuter l'aimantation de la couche de stockage lors de son refroidissement peut consister à injecter dans cette couche un courant d'électrons dont le spin est polarisé, suivant l'une des techniques qui sont mentionnées plus loin.

La présente invention consiste dans ce cas à combiner l'échauffement" du matériau de la couche de stockage qui permet de réduire le champ de retournement de l'aimantation de cette couche, avec l'application d'un couple magnétique à cette aimantation, lors du refroidissement de la couche de stockage, en faisant circuler un courant d'électrons dont le spin est polarisé à travers la couche de stockage.

Il est également possible de combiner la commutation; par application d'un champ local engendré par l'envoi d'un courant dans une ligne conductrice supérieure ou inférieure, avec l'injection d'un courant d'électrons à spin polarisé dans la couche de stockage de la jonction.

Quatre avantages majeurs de la présente invention peuvent être mis en avant:

1) Sélection sans faille des points mémoires:

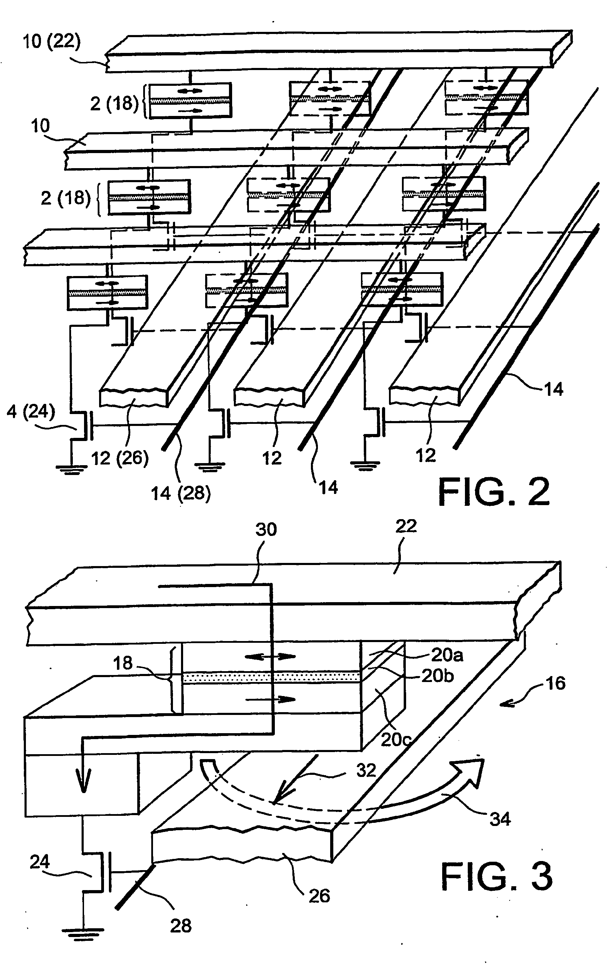

La présente invention permet une bien meilleure sélection des points mémoires que les techniques connues. En effet, supposons que les points mémoires soient organisés en un réseau carré comme on le voit sur la figure 2 qui représente l'architecture d'une mémoire MRAM connue.

Dans cette mémoire connue, on distingue trois niveaux de lignes :

- les lignes conductrices supérieures 10 qui servent à générer le champ magnétique Hx à appliquer aux jonctions tunnel magnétiques 2 lors de l'écriture et qui servent aussi de contacts électriques pour ces jonctions lors de la lecture,
- les lignes conductrices inférieures 12 qui servent uniquement à générer le champ magnétique Hy au moment de l'écriture, et
- les lignes de contrôle 14 qui agissent sur la grille des transistors 4 pour les mettre en position passante (saturée) ou fermée (bloquée).

Selon un procédé d'écriture connu, l'écriture se fait en envoyant des impulsions de courant le long des lignes conductrices supérieure et inférieure qui se croisent au point mémoire que l'on souhaite adresser. Or, s'il existe une distribution de champ de retournement, certains points mémoires situés le long des lignes risquent de se retourner de façon incontrôlée.

Dans la présente invention, ce problème ne se pose pas. Ceci est schématiquement illustré par la figure 3 où l'on voit un dispositif magnétique 16 conforme à l'invention, formant un point mémoire, ou cellule, d'une mémoire MRAM conforme à l'invention.

Ce point mémoire comprend une jonction tunnel magnétique 18, comportant une couche de stockage 20a, une couche de référence 20c et une couche isolante ou semiconductrice 20b entre ces dernières. Cette jonction est placée entre une ligne conductrice supérieure 22 et un transistor de commutation 24 et associée à une ligne conductrice inférieure 26 qui est perpendiculaire à la ligne 22.

En rendant passant le transistor 24 du point mémoire 16, ce transistor étant commandé par une ligne de contrôle 28, et en envoyant une impulsion de courant 30 dans la ligne conductrice supérieure 22 correspondante, cette impulsion de courant traverse la jonction 18 et provoque son échauffement.

Or les jonctions de la mémoire de la figure 3 sont organisées en réseau carré comme dans la mémoire de la figure 2 (dont les références des éléments sont d'ailleurs suivies, entre parenthèses, des références des éléments correspondants de la figure 3). Donc seule une jonction de tout le réseau sera échauffée par l'impulsion de courant 30, toutes les autres restant à température ambiante.

L'abaissement de champ de retournement lié à l'élévation de température (typiquement de 100 Oe, à 20°C, à 5 Oe, à 200°C) est beaucoup plus important que la largeur de la distribution de champ de retournement à température ambiante (typiquement 100 Oe $\pm$ 20 Oe).

En conséquence, en envoyant une impulsion de courant 32 dans la ligne conductrice inférieure 26, ce qui génère un champ magnétique 34 de l'ordre de 10 Oe pendant le refroidissement de la jonction adressée, on est sûr de ne faire commuter que l'aimantation de la couche de stockage 20a de cette jonction.

Cependant, la ligne 26 n'est pas indispensable pour créer le champ magnétique. On peut très bien utiliser la ligne supérieure 22 (utilisée dans un premier temps pour provoquer l'échauffement) pour générer dans un deuxième temps le champ magnétique lors du refroidissement.

Dans le cas de la figure 3, si l'on supprime la ligne 26, il faut veiller à ce que les directions d'aimantation des couches soient perpendiculaires à la ligne de courant 22 génératrice du champ magnétique (par exemple en faisant pivoter le dispositif).

Le fonctionnement du point mémoire 16 de la figure 3 est donc le suivant : le transistor d'adressage 24 étant à l'état passant, l'écriture se fait en envoyant une impulsion de courant à travers la jonction 18 pour échauffer la jonction jusque vers 200°C. Pendant le refroidissement de la jonction, une impulsion de courant est envoyée dans la ligne conductrice inférieure 26 pour générer un champ magnétique dans la couche de stockage 20a, qui a pour effet de faire commuter l'aimantation de cette couche dans la direction désirée.

La lecture se fait avec le transistor à l'état bloqué en faisant circuler un courant à travers la jonction (le courant étant plus faible que lors de l'écriture pour que l'échauffement soit moindre), ce qui permet d'en mesurer la résistance et donc de savoir si l'aimantation de la couche de stockage 20a est parallèle ou antiparallèle à celle de la couche de référence 20c.

2) Consommation réduite :

Compte tenu du fait que les champs à générer pour l'écriture sont beaucoup plus faibles que dans l'art antérieur (typiquement 10 Oe dans la présente invention contre 50 Oe dans l'art antérieur), l'intensité des impulsions de champ à envoyer dans les lignes conductrices est grandement réduite.

De plus, une seule impulsion dans la ligne conductrice inférieure est nécessaire dans le cas de la figure 3, contre une impulsion dans la ligne conductrice inférieure et une impulsion dans la ligne conductrice supérieure dans l'art antérieur.

La puissance nécessaire pour provoquer l'échauffement du point mémoire étant beaucoup plus faible que pour générer les impulsions de champ de 50 Oe (typiquement lpJ pour chauffer de 200°C une jonction tunnel magnétique de 150 nm x 150 nm contre plusieurs dizaines de pJ pour générer une impulsion de champ de 50 Oe le long d'une ligne de 500 points mémoires), il s'ensuit que la consommation électrique peut être divisée par 10 avec le principe de fonctionnement de la présente invention.

3) Stabilité de l'information pour de petites dimensions:

La présente invention permet d'utiliser, pour la couche de stockage, des matériaux à forte énergie de piégeage à température ambiante. Dans l'art antérieur, cela n'est pas possible car plus le piégeage de la couche de stockage est important, plus il faut fournir d'énergie pour faire commuter l'aimantation de la couche de stockage.

Dans la présente invention, on abaisse l'énergie de piégeage lors de l'écriture en échauffant le matériau. On peut donc se permettre d'avoir une énergie de piégeage forte à température ambiante. Cela présente un avantage considérable pour de petites dimensions. En effet, dans l'art antérieur, l'information stockée dans la couche de stockage devient instable par rapport aux fluctuations thermiques à température ambiante.

En effet, si K et V désignent respectivement l'anisotropie magnétique par unité de volume (ou, plus généralement, l'énergie de piégeage par unité de volume) et le volume de la couche de stockage, l'information devient instable si KV<25kT (où k est la constante de Boltzmann et T la température).

Pour un matériau donné, cette limite est toujours atteinte à un moment ou à un autre lorsqu'on diminue la taille du point mémoire alors que, dans la présente invention, on peut très bien compenser la diminution du volume par une augmentation de l'énergie de piégeage à température ambiante et donc réduire la taille du point mémoire autant que le permet le procédé de fabrication (par exemple lithographie/gravure) utilisé.

4) Simplicité de la réalisation si l'on utilise comme principe de commutation un échauffement plus une injection d'un courant d'électrons à spin polarisé :

En effet, il n'y a pas besoin, dans ce cas, de rajouter un niveau de lignes pour la génération des champs magnétiques locaux. La réalisation de l'ensemble des points mémoires s'en trouve simplifiée, ce qui peut permettre d'atteindre des densités d'intégration supérieures.

On reviendra plus loin sur l'utilisation, dans la présente invention, d'un courant d'électrons à spin polarisé.

On considère, dans ce qui suit, divers exemples de l'invention.

Comme on l'a vu plus haut, la structure de base, dans la présente invention, comporte deux couches magnétiques F1 et F2 séparées par une barrière tunnel O de sorte que l'on peut noter cette structure F1/O/F2. Les deux couches magnétiques sont telles que le champ de retournement de l'aimantation de l'une de ces deux couches magnétiques (la couche de stockage) décroît beaucoup plus vite, lorsque la température augmente, que celui de l'autre couche magnétique (la couche de référence).

Dans un premier mode de réalisation de l'invention, les aimantations des deux couches F1 et F2 sont perpendiculaires au plan des couches ou, plus précisément, aux interfaces de ces couches.

Des couches F1 et F2 peuvent être constituées d'un matériau pur, d'un alliage ou d'un ensemble de couches alternées dont certaines sont magnétiques.

Des couches de Co, de structure hexagonale, ont leur aimantation perpendiculaire au plan de ces couches si l'axe c de la maille hexagonale est perpendiculaire au plan de l'échantillon contenant ces couches. Des couches en alliages tels que CoPt, FePd et FePt peuvent aussi avoir des aimantations perpendiculaires à leur plan. Enfin, des multicouches comprenant une alternance de couches de deux matériaux différents dont au moins l'un est magnétique, comme par exemple Co 0,6nm/Pt 1,4nm, peuvent aussi avoir des aimantations perpendiculaires au plan.

Le cobalt peut être aisément remplacé par un alliage riche en Co (supérieur à 70%) avec par exemple du Fe ou du Ni ou du Cr.

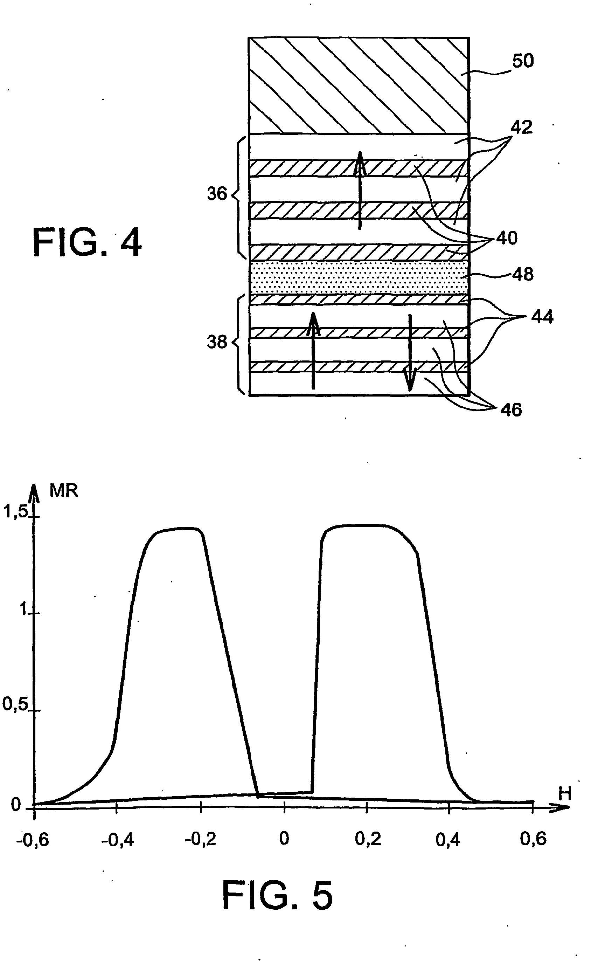

Un exemple de réalisation d'une jonction tunnel magnétique à base de multicouches Co/Pt, qui est utilisable dans la présente invention, est montré sur la figure 4.

Plus précisément, comme on le voit sur la figure 4, cette jonction tunnel magnétique comprend une couche de référence 36 et une couche de stockage 38 qui ont une aimantation perpendiculaire au plan de ces couches; la couche de référence 36 comprend des couches 40 en cobalt qui alternent avec des couches 42 en platine; de même, la couche de stockage 38 comprend des couches 44 en cobalt qui alternent avec des couches 46 en platine; les couches 36 et 38 sont séparées par une couche de barrière tunnel 48 en alumine.

En jouant sur les épaisseurs relatives de Co et de Pt, on peut faire varier la coercitivité du matériau constitutif de chacune des couches 36 et 38 ainsi que la variation de cette coercitivité en fonction de la température. On peut aussi augmenter l'énergie de piégeage de l'aimantation de l'une des couches (la couche de référence 36) en la couplant à un matériau antiferromagnétique 50 à forte température de blocage, comme PtMn ou PtPdMn.

Dans ce cas, la couche ferromagnétique adjacente voit la valeur de sa température de blocage augmenter jusqu'à la valeur de celle de la couche antiferromagnétique.

D'autres exemples de multicouches à anisotropie perpendiculaire, utilisables dans l'invention, sont par exemple Co/Pd, Co/Ni, Cu/Ni.

A titre d'exemple, la figure 5 montre qu'on peut obtenir une structure à aimantation perpendiculaire au plan, qui associe deux multicouches de coercivités différentes.

On a tracé les variations de la magnétorésistance MR (en%) en fonction du champ magnétique appliqué H (en kOe) pour la structure

$$NiO_{300}/CO_6/ (Pt_{18}/CO_6)_2/Cu_{30}/ (CO_6/Pt_{18})_2.$$

Dans le cas de la figure 5, l'augmentation de coercitivité de l'une des multicouches est obtenue en couplant l'aimantation de cette multicouche a une couche antiferromagnétique adjacente (par exemple NiO (cas de la figure 5), PtMn, PdPtMn ou FeMn).

Le même résultat pourrait être obtenu en associant une multicouche de Co/Pt à un alliage de FePt.

Par ailleurs, chacun des matériaux précités a sa propre variation de champ coercitif en fonction de la température.

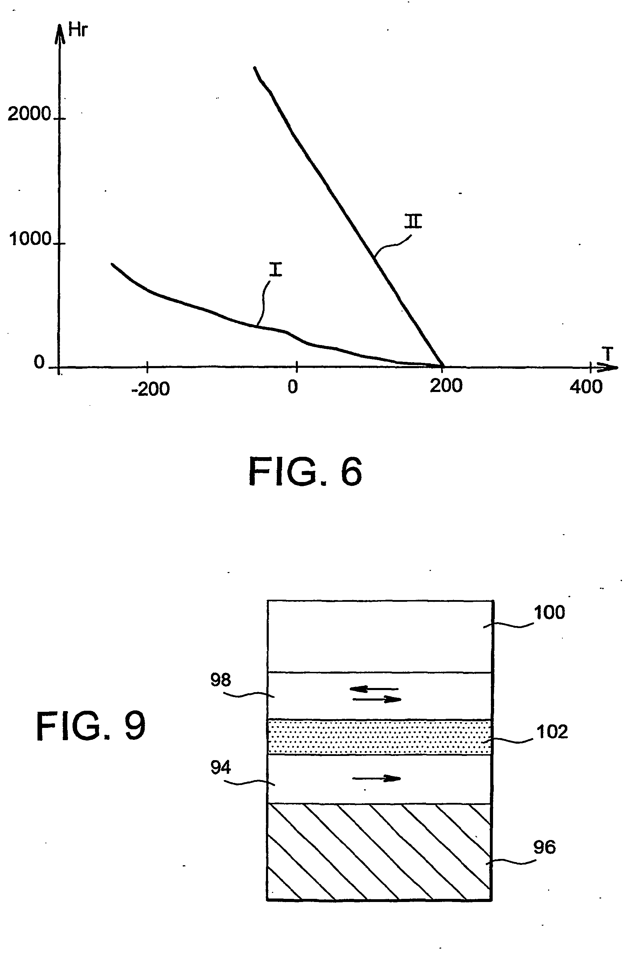

La figure 6 montre par exemple les variations du champ de retournement Hr (en Oe) d'une multicouche (Co 0,6nm/Pt 1,4nm) en fonction de la température T (en °C) pour une plaque "pleine tranche", de dimension latérale macroscopique (courbe I), et dans des réseaux (en anglais "arrays") de plots de dimensions submicroniques (courbe II).

Pour les épaisseurs de Co et de Pt utilisées, le champ de retournement Hr décroît rapidement avec la température pour quasiment s'annuler à une température Tc de l'ordre de 200°C.

Si l'on augmente l'épaisseur de Co à épaisseur de Pt fixe, le champ de retournement décroît moins vite, c'est à dire s'annule à une température supérieure à 200°C. De même, dans l'alliage FePt, le champ de retournement s'annule vers 500°C.

Donc en réalisant par exemple une jonction tunnel magnétique qui associe une multicouche, formée d'une alternance de couches de Co et de couches de Pt, avec une électrode en alliage FePt, on réalise une structure conforme à l'invention. En envoyant une impulsion de courant à travers la jonction, on élève la température de cette dernière jusque vers 200°C.

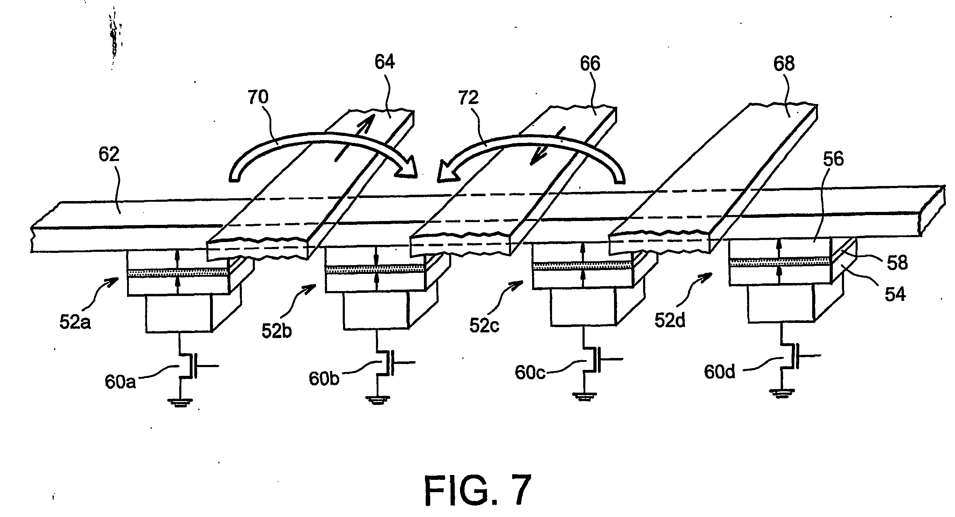

On coupe alors le courant qui circulait à travers la jonction et, pendant le refroidissement de cette jonction, on applique un faible champ magnétique à l'aide de lignes conductrices inférieures ou supérieures (voir la figure 7). L'aimantation de la couche de référence demeure inchangée alors que celle de la couche de stockage s'oriente dans la direction du champ appliqué pendant le refroidissement.

Plus précisément, la figure 7 illustre un exemple de réalisation d'un ensemble de plusieurs points mémoires à partir de jonctions tunnel à aimantation perpendiculaire au plan selon la présente invention. Ces jonctions 52a, 52b, 52c et 52d comprennent chacune une couche de référence 54, une couche de stockage 56 et, entre celles-ci, une couche isolante ou semiconductrice 58. Ces jonctions 52a, 52b, 52c et 52d sont comprises entre des transistors de commutation 60a, 60b, 60c et 60d et une ligne conductrice 62.

On voit aussi des lignes conductrices supérieures, telle que les lignes 64, 66 et 68, qui sont situées de part et d'autre des jonctions.

Pour l'écriture d'un point mémoire, par exemple celui qui comprend la jonction 52b, cette jonction est chauffée au dessus de la température de blocage de la couche de stockage mais en dessous de la température de blocage de la couche de référence par l'envoi d'une impulsion à travers la jonction.

De plus, les transistors sont mis à l'état bloqué sauf le transistor 60b associé à la jonction 52b, qui est mis à l'état passant.

Les deux lignes conductrices supérieures 64 et 66 situées de part et d'autre de la jonction à adresser 52b sont alimentées par des courants sensiblement opposés pour créer deux champs magnétiques 70 et 72 sensiblement perpendiculaires au plan, qui s'ajoutent au niveau de la jonction à adresser. Ces champs servent à polariser l'aimantation de la couche de stockage pendant son refroidissement en dessous de sa température de blocage. L'aimantation de la couche de stockage peut prendre ici deux états (stockage binaire).

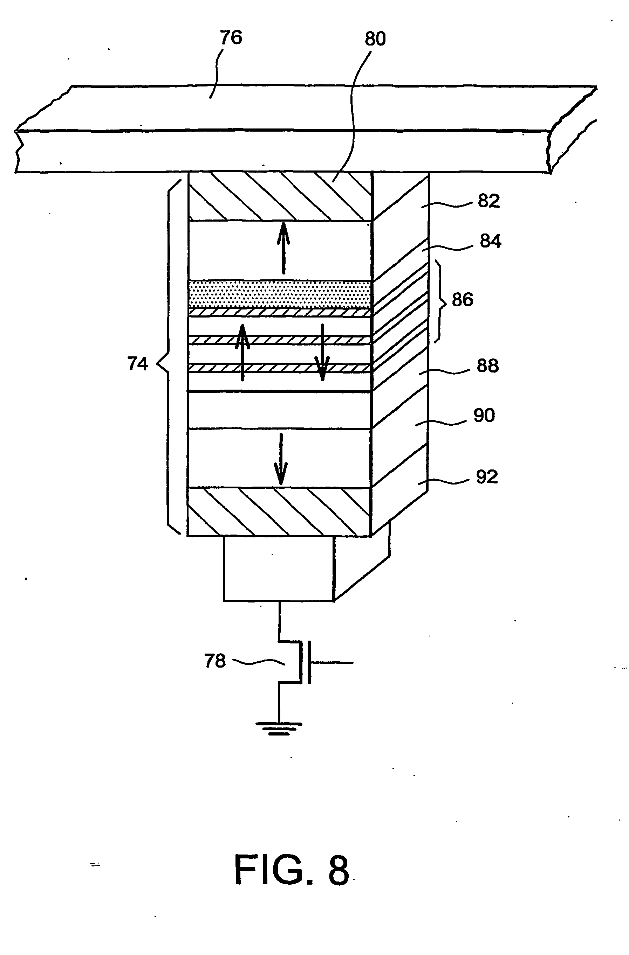

Une deuxième méthode pour réaliser la commutation lors du refroidissement consiste à injecter un courant d'électrons à spin polarisé à travers la couche de stockage. Une structure permettant de réaliser cette opération est représentée sur la figure 8.

Sur cette figure 8, on voit un empilement 74 compris entre une ligne conductrice supérieure 76 et un transistor de commutation 78. L'empilement comprend, en allant de la ligne 76 au transistor 78, une couche 80 en PtMn, une couche de référence 82, une couche d'alumine 84, une couche de stockage 86, une couche de cuivre 88, une couche 90 dite "polarisante" et une couche 92 en PtMn.

La couche de stockage 86 est constituée ici d'un matériau à aimantation perpendiculaire dont le champ de retournement s'annule vers 200°C tel que par exemple une multicouche (Co/Pt). La couche de référence 82 est constituée d'un matériau dont le champ de retournement et l'aimantation restent importants à 200°C, comme par exemple FePt. De même, l'aimantation de la deuxième couche magnétique de FePt formant la couche polarisante 90 reste importante à 200°C.

Le principe de la commutation magnétique est le suivant: on applique une impulsion de courant soit de haut en bas soit de bas en haut à travers la jonction tunnel.

Cette impulsion de courant a un profil particulier: elle monte à sa valeur maximum en un temps de l'ordre de lns à quelques nanosecondes puis redescend progressivement à zéro en quelques nanosecondes. Cette impulsion de courant a pour effet, dans un premier temps, d'échauffer la jonction puis, dans un deuxième temps, lors de la décroissance du courant c'est à dire lors du refroidissement de la jonction, d'orienter l'aimantation dans une direction particulière.

Si le courant circule de haut en bas (c'est à dire si les électrons circulent de bas en haut), des électrons à spin polarisé « vers le bas » sont injectés dans la multicouche de Co/Pt. De plus, les électrons qui vont traverser par effet tunnel la barrière d'alumine 84 sont préférentiellement des électrons dont le spin est parallèle à l'aimantation de la couche 82 de FePt et sont donc des électrons à spin « vers le haut ».

Cela va générer, dans la multicouche de Co/Pt, un excès d'électrons vers le bas. Cet excès d'électrons vers le bas, cumulé avec l'injection d'électrons vers le bas en provenance de la couche polarisante inférieure, va forcer l'aimantation de la multicouche de Co/Pt à s'orienter vers le bas lors de son refroidissement.

Au contraire, si le courant circule de bas en haut (c'est à dire si les électrons circulent de haut en bas), il va y avoir accumulation d'électrons « vers le haut » dans la couche de Co/Pt, ce qui aura pour effet de forcer l'aimantation de cette couche à s'orienter vers le haut lors de son refroidissement.

Précisons que ce principe de commutation magnétique pourrait fonctionner également sans la couche polarisante inférieure mais la forme de l'impulsion de courant serait alors plus difficile à ajuster pour trouver un bon équilibre entre une réduction du courant suffisante pour que la température de la jonction baisse suffisamment et une circulation de courant suffisante pour arriver à polariser l'aimantation de la couche de stockage lors de son refroidissement.

L'intérêt de la couche polarisante supplémentaire 90 est de permettre de cumuler le courant d'électrons à spin polarisé provenant de l'autre couche 82 de la jonction tunnel et le courant d'électrons à spin polarisé provenant de la couche polarisante 90.

Cette structure du point mémoire est particulièrement simple puisqu'elle ne nécessite, en plus du transistor d'adressage et de la jonction tunnel, qu'un niveau de ligne conductrice.

Dans un deuxième mode de réalisation de l'invention, les aimantations des deux couches F1 et F2 sont parallèles au plan des couches ou, plus précisément, aux interfaces de ces couches.

Comme précédemment, les matériaux magnétiques constitutifs de la jonction tunnel magnétique doivent être choisis de sorte que l'un présente une décroissance thermique de son champ coercitif plus rapide que l'autre.

Le matériau de la couche F2 de référence peut être en alliage à base de Co, Fe, Ni (par exemple $Co_{90}Fe_{10}$) et son aimantation peut être piégée par interaction d'échange avec un matériau antiferromagnétique à forte température de blocage (très supérieure à 200°C) comme PtMn.

Le matériau de la couche F1 peut être constitué d'un alliage dont la température de Curie est réduite en volume pour permettre de faciliter le basculement de son aimantation lorsque ce matériau est chauffé vers 200°C.

Un mode avantageux de réalisation de cette propriété consiste à coupler l'aimantation de la couche de stockage à une couche antiferromagnétique à faible température de blocage (par exemple $Fe_{50}Mn_{50}$ ou $Ir_{20}Mn_{80}$ dont la température de blocage est inférieure à 200°C tandis que l'aimantation de l'autre couche magnétique (la couche de référence) est couplée à un matériau antiferromagnétique à forte température de blocage, par exemple PtMn dont la température de blocage est supérieure à 280°C.

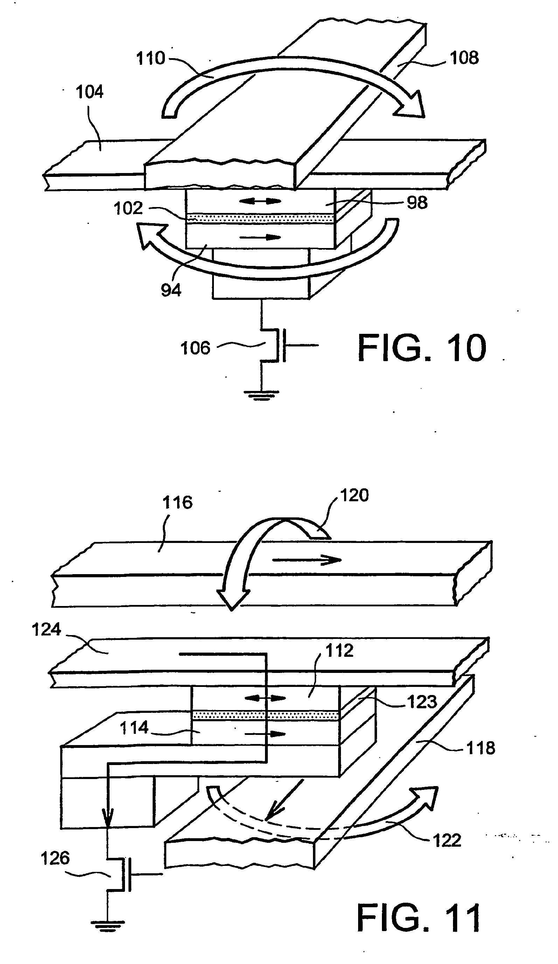

Ceci est schématiquement illustré par la figure 9 où l'on voit un exemple de jonction tunnel à aimantation planaire utilisable dans la présente invention.

La couche de référence 94 en $Co_{90}Fe_{10}$ est piégée par interaction avec une couche antiferromagnétique 96 à haute température de blocage (très supérieure à 200°C), par exemple en PtMn ou en NiMn.

La couche de stockage 98 en $Ni_{80}Fe_{20}$ est couplée à une couche antiferromagnétique 100 à faible température de blocage (compris entre 100°C et 200°C), par exemple en $Fe_{50}Mn_{50}$ ou en $Ir_{20}Mn_{80}$ et cette couche 98 est séparée de la couche 94 par une couche de barrière tunnel 102 en $Al_2O_3$.

Notons qu'une façon de faire baisser la température de blocage de la couche antiferromagnétique couplée à la couche de stockage peut être de diminuer son épaisseur. On sait en effet que plus une couche antiferromagnétique est mince, plus sa température de blocage est basse.

L'écriture de l'information se fait comme précédemment en envoyant une impulsion de courant à travers la jonction, impulsion qui a pour effet d'échauffer le matériau de la couche de stockage (comprenant la couche antiferromagnétique adjacente) à une température permettant le retournement de l'aimantation de cette couche, alors que la couche de référence reste à une température suffisamment faible pour que son aimantation reste fixe.

Ceci est schématiquement illustré par la figure 10 où l'on voit un exemple de réalisation d'un point mémoire à partir d'une jonction tunnel à aimantation planaire conformément à la présente invention.

Pour l'écriture, la jonction est chauffée au dessus de la température de blocage de la couche de stockage 98 mais en dessous de la température de blocage de la couche de référence 94, par l'envoi d'une impulsion de courant à travers la jonction, cette impulsion se propageant de la ligne conductrice 104 au transistor 106, qui est alors rendu passant.

La ligne conductrice supérieure 108 sert à créer le champ magnétique 110 qui polarise l'aimantation de la couche de stockage 98 dans la direction désirée pendant son refroidissement. Cette aimantation de la couche de stockage ne peut prendre ici que deux états (stockage binaire).

Pour des raisons déjà données plus haut à propos d'autres exemples, la ligne 108 n'est pas obligatoire : sa fonction peut être avantageusement réalisée par la ligne 104. Dans ce cas, il faut aussi veiller à ce que les directions d'aimantation des couches soient orthogonales à la direction de la ligne 104.

Ce dispositif, dans lequel la couche de stockage est couplée à une couche antiferromagnétique dont la température de blocage est plus faible que la couche de référence, présente deux avantages majeurs:

1) La limite superparamagnétique de stabilité de la couche de stockage est repoussée de sorte que l'on peut réaliser des points mémoires de taille plus petite en utilisant cette technique.

En effet, un problème qui apparaît toujours dans le stockage de l'information magnétique dans des points mémoires de petites dimensions (échelle submicronique) est celui de la stabilité de l'aimantation vis à vis des fluctuations thermiques (limite superparamagnétique).

Si K désigne l'anisotropie magnétique du matériau et V le volume de la couche magnétique de stockage, le temps caractéristique de renversement de l'aimantation par passage au dessus de la barrière d'énergie de hauteur KV est $\tau = \tau_0 \exp(KV/(kT))$ où $\tau_0$ est un temps caractéristique d'essai de l'ordre de $10^{-9}$ seconde, k la constante de Boltzman et T la température.

Pour que l'information que l'on écrit dans la couche de stockage reste stable pendant au moins 10 ans, il faut que l'aimantation elle-même reste stable pendant cette durée. Il faut donc que $\dfrac{KV}{kT} > \text{Log}(10\text{ans}/10^{-9}\text{s})$

c'est-à-dire : KV > 40kT.

Ceci impose une limite minimale au volume de la couche de stockage et donc à sa dimension latérale, c'est à dire une limite minimale à la dimension du point mémoire.

Par contre, si la couche magnétique de stockage est couplée à une couche antiferromagnétique dont l'anisotropie est relativement forte à température ambiante mais décroît rapidement lorsqu'on approche de la température de blocage de cette couche (vers 200°C), alors la limite superparamagnétique est repoussée.

En effet, la barrière d'énergie à franchir pour retourner l'aimantation de la couche de stockage à température ambiante vaut maintenant $A(K_f E_f + K_a E_a)$ où A désigne l'aire commune à la couche magnétique de stockage et à la couche antiferromagnétique, $E_f$ et $E_a$ désignent respectivement les épaisseurs de ces couches de stockage et antiferromagnétique et $K_f$ et $K_a$ désignent respectivement leurs anisotropies magnétiques.

Comme l'anisotropie $K_a$ du matériau antiferromagnétique est habituellement beaucoup plus forte que celle ($K_f$) de la couche ferromagnétique de stockage à température ambiante, il apparaît que la condition de stabilité $A(K_f E_f + K_a E_a) > 40kT$ pourra être satisfaite pour des dimensions beaucoup plus petites que si la couche magnétique de stockage était seule.

Typiquement, le terme $K_a E_a$ peut être 100 fois plus grand à température ambiante que le terme $K_f E_f$. Ceci implique que l'aire de la jonction peut être 100 fois plus petite tout en restant au dessus de la limite superparamagnétique. Ceci permet donc d'atteindre des densités d'intégration beaucoup plus fortes.

Précisons qu'il est également possible d'utiliser ce couplage de la couche de stockage à une couche antiferromagnétique à faible température de Néel dans le cas précédemment décrit de couches magnétiques à aimantation perpendiculaire au plan. Là aussi, la limite superparamagnétique sera repoussée vers les plus petites dimensions à température ambiante.

2) Le deuxième avantage très important résultant de l'utilisation d'une couche de stockage couplée à une couche antiferromagnétique est de pouvoir réaliser un stockage de l'information multiniveaux.

En effet, avec les jonctions de l'art antérieur, un point mémoire a deux états possibles qui correspondent aux deux configurations magnétiques parallèle et antiparallèle, ces dernières correspondant respectivement à des alignements parallèle et antiparallèle de l'aimantation de la couche de stockage par rapport à celle de la couche de référence.

Ces systèmes de type bistables sont obtenus en donnant à la couche de stockage une anisotropie magnétique d'origine magnétocristalline ou de forme (point mémoire par exemple de forme elliptique), avec un axe facile d'aimantation parallèle à l'aimantation de la couche de référence.

Dans la présente invention, l'aimantation de la couche de stockage peut être avantageusement orientée dans n'importe quelle direction intermédiaire entre la direction parallèle et la direction antiparallèle à l'aimantation de la couche de référence.

Pour ce faire, il suffit de chauffer la couche de stockage et la couche antiferromagnétique adjacente au dessus de la température de blocage de cette couche, en envoyant une impulsion de courant à travers la jonction, puis d'orienter l'aimantation de la couche de stockage dans la direction désirée au cours du refroidissement de la couche antiferromagnétique.

Pour donner l'orientation désirée à l'aimantation de la couche de stockage, il faut appliquer un champ magnétique local à cette dernière dans la direction désirée. Pour ce faire, deux possibilités existent:

1) On peut utiliser une architecture dans laquelle la commutation magnétique s'effectue en envoyant des impulsions de courant dans des lignes conductrices perpendiculaires qui sont respectivement situées au dessus et en dessous de ce point mémoire.

Ces lignes permettent de générer des champs magnétiques suivant deux directions perpendiculaires. En jouant sur l'intensité relative du courant circulant dans les deux lignes, on peut générer un champ magnétique dans n'importe quelle direction du plan.

Ceci est schématiquement illustré par la figure 11 qui montre un exemple de réalisation d'un point mémoire à partir d'une jonction tunnel à aimantation planaire conformément à la présente invention.

Pour l'écriture, la jonction tunnel magnétique est chauffée au dessus de la température de blocage de la couche de stockage 112 mais en dessous de la température de blocage de la couche de référence 114, par l'envoi d'une impulsion de courant à travers la jonction.

Les lignes conductrices supérieure 116 et inférieure 118 servent à créer des champs magnétiques 120 et 122 suivant deux directions perpendiculaires dans le plan, qui permettent de polariser l'aimantation de la couche de stockage 112 dans n'importe quelle direction désirée dans le plan de la jonction, pendant son refroidissement.
Comme on l'a déjà expliqué précédemment à propos de la figure 10, la ligne 116 n'est pas indispensable: elle peut être remplacée par la ligne 124.

L'aimantation de la couche de stockage peut donc prendre ici plus de deux états (stockage multiniveaux).

Sur la figure 11, la référence 123 désigne la couche de barrière tunnel. On voit aussi la ligne conductrice 124 et le transistor de commutation 126 entre lesquels la jonction est comprise et qui permettent de faire circuler un courant à travers cette jonction lorsque le transistor fonctionne en mode saturé.

2) On peut aussi utiliser la combinaison d'un champ magnétique créé comme précédemment, en faisant circuler un courant dans une ligne conductrice située au dessus ou en dessous de la jonction tunnel, avec le couple magnétique exercé par l'injection d'un courant d'électrons à spin polarisé à travers la jonction tunnel, dans la couche magnétique de stockage.

Dans ce cas, l'aimantation de la couche magnétique créant la polarisation du spin des électrons injectés devra être sensiblement perpendiculaire au champ magnétique généré par le courant circulant dans la ligne conductrice.

Il est également important dans ce cas de faire en sorte que la densité de courant nécessaire pour orienter l'aimantation de la couche de stockage dans la direction désirée soit sensiblement inférieure à celle qui est nécessaire à l'échauffement de la jonction de sorte que la jonction soit bien dans une phase de refroidissement en dessous de la température de blocage de la couche antiferromagnétique couplée à la couche de stockage durant ce processus d'écriture.

La lecture se fait en mesurant le niveau de résistance de la jonction.

En effet, la résistance varie suivant la loi

$$R = R_{par}\left[1 + \left(\frac{\Delta R}{R_{par}}\right)\left(\frac{1 - \cos(\theta_s - \theta_p)}{2}\right)\right]$$

où $\theta_s$ et $\theta_p$ représentent respectivement les angles repérant respectivement les aimantations de la couche de stockage et de la couche piégée, ou couche de référence, dans le plan de la jonction.

$$\Delta R/R_{par} = (R_{ant} - R_{par})/R_{par}$$

est l'amplitude totale de magnétorésistance.

La lecture du niveau de résistance intermédiaire entre la résistance parallèle $R_{par}$ et la résistance antiparallèle $R_{ant}$ permet donc de déterminer la direction de l'aimantation de la couche de stockage.

Dans les structures décrites précédemment, il est possible d'insérer de minces couches d'un autre matériau à l'interface entre la couche magnétique et la couche de barrière tunnel.

Ces minces couches peuvent être des couches magnétiques, destinées à renforcer la polarisation des électrons au voisinage de l'interface avec la couche de barrière tunnel, ou des couches non magnétiques permettant de réaliser des puits quantiques dépendant du spin au voisinage de la couche barrière tunnel ou d'augmenter le découplage magnétique des deux couches magnétiques de part et d'autre de la jonction tunnel.

**Revendications**

1. Dispositif magnétique (16) comprenant une jonction tunnel magnétique (18; 52a, 52b, 52c, 52d; 74) qui comporte :

   - une première couche magnétique (20c, 36, 54, 82, 94, 114) formant une couche de référence et ayant une aimantation de direction fixe,
   - une deuxième couche magnétique (20a, 38, 56, 86, 98, 112) formant une couche de stockage et ayant une aimantation de direction variable, et
   - une troisième couche (20b, 48, 58, 84, 102, 123) qui est semiconductrice ou électriquement isolante et qui sépare la première couche de la deuxième couche,

ce dispositif étant **caractérisé en ce que** la température de blocage de l'aimantation de la couche de stockage est inférieure à la température de blocage de l'aimantation de la couche de référence et **en ce que** le dispositif comprend en outre :

- des moyens d'échauffement de la couche de stockage à une température supérieure à la température de blocage de l'aimantation de cette couche de stockage, les moyens d'échauffement de la couche de stockage étant des moyens (22, 24; 62, 60a, 60b, 60c, 60d; 76, 78; 104, 106; 124, 126) prévus pour faire circuler un courant d'électrons à travers la jonction tunnel magnétique, et
- des moyens d'application, à cette couche de stockage, d'un champ magnétique (26, 64, 66, 68; 108; 116, 118) et/ou d'un couple magnétique (82, 90) apte à orienter l'aimantation de cette couche de stockage par rapport à l'aimantation de la couche de référence, sans modifier l'orientation de cette couche de référence.

2. Dispositif selon la revendication 1, dans lequel les températures de blocage des couches de stockage et de référence ont des valeurs supérieures à la valeur de la température de fonctionnement du dispositif hors échauffement de la jonction tunnel.

3. Dispositif selon l'une quelconque des revendications 1 et 2, dans lequel l'aimantation de chacune des couches de stockage (38, 56, 86) et de référence (36, 54, 82) est sensiblement perpendiculaire au plan de ces couches.

4. Dispositif selon la revendication 3, dans lequel la couche de stockage (38) est une monocouche en alliage Co-Pt ou Co-Pd ou une multicouche formée par un empilement de couches (44) de Co alternant avec des couches (46) de Pt ou de Pd de façon que le champ coercitif de la couche de stockage diminue rapidement quand la température augmente.

5. Dispositif selon la revendication 3, dans lequel la couche de stockage est une monocouche en alliage riche en cobalt avec du fer ou du nickel ou du chrome ainsi que du platine ou du palladium, ou une multicouche formée par un empilement de couches d'un alliage riche en cobalt avec du fer ou du nickel ou du chrome, alternant avec des couches de Pt ou de Pd de façon que le champ coercitif de la couche de stockage diminue rapidement quand la température augmente.

6. Dispositif selon l'une quelconque des revendications 1 et 2, dans lequel l'aimantation de chacune des couches de stockage (20a, 98, 112) et de référence (20c, 94, 114) est sensiblement parallèle au plan de ces couches.

7. Dispositif selon l'une quelconque des revendications 1 à 6, comprenant en outre une première couche antiferromagnétique (50, 80, 96) associée à la couche de référence.

8. Dispositif selon la revendication 7, dans lequel la température de blocage de l'aimantation de cette première couche antiferromagnétique (50, 80, 96) est supérieure à la température de blocage de la couche de stockage.

9. Dispositif selon l'une quelconque des revendications 1 à 8, dans lequel la couche de référence est une multicouche comprenant deux couches magnétiques et une couche intermédiaire en Ru ou en Re ou en Ir ou en Rh, les deux couches magnétiques étant séparées par la couche intermédiaire et couplées de façon antiparallèle par interaction à travers cette couche intermédiaire.

10. Dispositif selon l'une quelconque des revendications 1 à 9, comprenant en outre une deuxième couche antiferromagnétique (100) couplée à la couche de stockage par anisotropie d'échange.

11. Dispositif selon la revendication 10, dans lequel la température de blocage de l'aimantation de cette deuxième couche antiferromagnétique (100) est inférieure à la température de blocage de la couche de référence.

12. Dispositif selon l'une quelconque des revendications 1 à 10, **caractérisé en ce que** les moyens d'application du champ magnétique (26, 64, 66, 68 ; 108 ; 116, 118) comprennent au moins une ligne conductrice apte à porter une impulsion de courant pour générer un champ magnétique dans la couche de stockage.

13. Dispositif selon l'une quelconque des revendications 1 à 12, dans lequel les moyens d'application du couple magnétique (82, 90) à la couche de stockage (86) comprennent des moyens d'injection, dans cette couche de stockage, d'un courant d'électrons dont le spin est polarisé.

**14.** Dispositif selon la revendication 13, **caractérisée en ce que** les moyens d'application du couple magnétique (82, 90) comprennent au moins une couche polarisante à laquelle est appliquée une impulsion de courant pour produire des électrons à spin polarisé.

**15.** Mémoire comprenant une matrice de points mémoires adressables par des lignes et des colonnes d'adressage, cette mémoire étant **caractérisée en ce que** chaque point mémoire comprend:

- un dispositif magnétique (16) selon l'une quelconque des revendications 1 à 14, et
- un moyen (24) de commutation de courant placé en série avec ce dispositif magnétique,

chaque dispositif magnétique étant relié à une ligne d'adressage (22) et chaque moyen de commutation étant relié à une colonne d'adressage (28).

**16.** Procédé d'écriture d'une information dans un dispositif magnétique conforme à l'une quelconque des revendications 1 à 14, dans lequel

- on chauffe la couche de stockage (20a, 38, 56, 86, 98, 112) à une température supérieure à la température de blocage de l'aimantation de cette couche de stockage et
- pendant le refroidissement de la couche de stockage, on applique à cette couche de stockage un champ ou couple magnétique apte à orienter l'aimantation de cette couche de stockage par rapport à l'aimantation de la couche de référence (20c, 36, 54, 82, 94, 114), sans modifier l'orientation de cette couche de référence.

**17.** Procédé selon la revendication 16, dans lequel la valeur, vue par la couche de référence, du champ magnétique (34, 72, 110, 120) ou du couple magnétique appliqué au cours de l'écriture, est inférieure au champ ou couple magnétique nécessaire au retournement de l'aimantation de la couche de référence à la température maximale atteinte par cette couche au cours de l'échauffement de la jonction.

**18.** Procédé selon l'une quelconque des revendications 16 et 17, dans lequel la couche de stockage est couplée à une couche antiferromagnétique (100) par anisotropie d'échange et l'on chauffe la couche de stockage et cette couche antiferromagnétique à une température supérieure aux températures de blocage de l'aimantation de ces couches et, au cours du refroidissement de la couche antiferromagnétique, on oriente l'aimantation de la couche de stockage dans une direction quelconque prédéfinie par la direction d'aimantation du champ magnétique appliqué lors du refroidissement.

**19.** Procédé de lecture d'une information mémorisée dans le dispositif magnétique selon l'une quelconque des revendications 1 à 14, dans lequel

- on détermine la valeur de la résistance de la jonction tunnel magnétique (18; 52a, 52b, 52c, 52d; 74), et
- on déduit l'orientation de l'aimantation de la couche de stockage à partir de cette valeur de la résistance.

**Claims**

**1.** Magnetic device (16) comprising a magnetic tunnel junction (18; 52a, 52b, 52c, 52d; 74) which includes:

- a first magnetic layer (20c, 36, 54, 82, 94, 114) forming a reference layer and having a magnetisation of fixed direction,
- a second magnetic layer (20a, 38, 56, 86, 98, 112) forming a storage layer and having a variable magnetisation direction, and
- a third layer (20b, 48, 58, 84, 102, 123) which is a semiconductor layer or an electrically insulative layer and which separates the first layer from the second layer,

this device being **characterised in that** the magnetisation blocking temperature of the storage layer is lower than the magnetisation blocking temperature of the reference layer and **in that** the device further comprises:

- means for heating the storage layer to a temperature higher than the magnetisation blocking temperature of that storage layer, the storage layer heating means being means (22, 24; 62, 60a, 60b, 60c, 60d; 76, 78; 104, 106; 124, 126) provided for circulating a current of electrons across the magnetic tunnel junction, and

- means for applying to this storage layer a magnetic field (26, 64, 66, 68; 108; 116, 118) and/or a magnetic torque (82, 90) adapted to orient the magnetisation of this storage layer relative to the magnetisation of the reference layer without modifying the orientation of this reference layer.

2. Device according to claim 1, wherein the blocking temperatures of the storage and reference layers have values higher than the value of the operating temperature of the device when there is no heating of the tunnel junction.

3. Device according to either of claims 1 and 2, wherein the magnetisation of each of the storage layer (38, 56, 86) and the reference layer (36, 54, 82) is substantially perpendicular to the plane of these layers.

4. Device according to claim 3, wherein the storage layer (38) is a single layer of Co-Pt or Co-Pd alloy or a multilayer formed of a stack of layers (44) of Co alternating with layers (46) of Pt or Pd so that the coercive field of the storage layer decreases rapidly when the temperature increases.

5. Device according to claim 3, wherein the storage layer is a single layer of cobalt-rich alloy with iron or nickel or chromium as well as platinum or palladium, or a multilayer formed by a stack of layers of a cobalt-rich alloy with iron or nickel or chromium, alternating with layers of Pt or Pd so that the coercive field of the storage layer decreases rapidly as the temperature increases.

6. Device according to either of claims 1 and 2, wherein the magnetisation of each of the storage layer (20a, 98, 112) and the reference layer (20c, 94, 114) is substantially parallel to the plane of these layers.

7. Device according to any one of claims 1 to 6, further comprising a first antiferromagnetic layer (50, 80, 96) associated with the reference layer.

8. Device according to claim 7, wherein the magnetisation blocking temperature of this first antiferromagnetic layer (50, 80, 96) is higher than the blocking temperature of the storage layer.

9. Device according to any one of claims 1 to 8, wherein the reference layer is a multilayer comprising two magnetic layers and an intermediate layer of Ru or of Re or of Ir or of Rh, the two magnetic layers being separated by the intermediate layer and coupled in antiparallel fashion by interaction through this intermediate layer.

10. Device according to any one of claims 1 to 9, further comprising a second antiferromagnetic layer (100) coupled to the storage layer by exchange anisotropy.

11. Device according to claim 10, wherein the magnetisation blocking temperature of this second antiferromagnetic layer (100) is lower than the blocking temperature of the reference layer.

12. Device according to any one of claims 1 to 10, **characterised in that** the means for applying the magnetic field (26, 64, 66, 68; 108; 116, 118) comprise at least one conductive line adapted to carry a current pulse to generate a magnetic field in the storage layer.

13. Device according to any one of claims 1 to 12, wherein the means for applying the magnetic torque (82, 90) to the storage layer (86) comprise means for injecting into this storage layer a current of electrons the spin whereof is polarised.

14. Device according to claim 13, **characterised in that** the means for applying the torque (82, 90) comprise at least one polarising layer to which a current pulse is applied to produce polarised spin electrons.

15. Memory comprising a matrix of memory points addressable by addressing rows and columns, this memory being **characterised in that** each memory point comprises:

- a magnetic device (16) according to any one of claims 1 to 14, and
- current switching means (24) disposed in series with this magnetic device,

each magnetic device being connected to an addressing row (22) and each switching means being connected to an addressing column (28).

**16.** Method of writing information into a magnetic device according to any one of claims 1 to 14, wherein

- the storage layer (20a, 38, 56, 86, 98, 112) is heated to a temperature higher than the magnetisation blocking temperature of this storage layer and
- during cooling of the storage layer, there is applied to this storage layer a magnetic field or torque adapted to orient the magnetisation of this storage layer relative to the magnetisation of the reference layer (20c, 36, 54, 82, 94, 114), without modifying the orientation of this reference layer.

**17.** Method according to claim 16, wherein the value, seen by the reference layer, of the magnetic field (34, 72, 110, 120) or of the magnetic torque applied during writing is less than magnetic field or torque needed to reverse the magnetisation of the reference layer at the maximum temperature reached by that layer during the heating of the junction.

**18.** Method according to either of claims 16 and 17, wherein the storage layer is coupled to an antiferromagnetic layer (100) by exchange anisotropy and the storage layer and this antiferromagnetic layer are heated to a temperature higher than the magnetisation blocking temperatures of these layers and, during cooling of the antiferromagnetic layer, the magnetisation of the storage layer is oriented in any direction predefined by the magnetisation direction of the magnetic field applied during cooling.

**19.** Method of reading information memorised in the magnetic device according to any one of claims 1 to 14, wherein

- the value of the resistance of the magnetic tunnel junction (18; 52a, 52b, 52c, 52d; 74) is determined, and
- the orientation of the magnetisation of the storage layer is deduced from this value of the resistance.

**Patentansprüche**

**1.** Magnetische Vorrichtung (16), umfassend eine magnetische Tunnelgrenzschicht (18; 52a, 52b, 52c, 52d; 74), die umfasst:

- eine erste, eine Bezugsschicht bildende magnetische Schicht (20c, 36, 54, 82, 94, 114) mit einer Magnetisierung von festgelegter Richtung,
- eine zweite, eine Speicherschicht bildende magnetische Schicht (20a, 38, 56, 86, 98, 112) mit einer Magnetisierung von veränderlicher Richtung und
- eine dritte Schicht (20b, 48, 58, 84, 102, 123), die halbleitend oder elektrisch isolierend ist und die die erste Schicht von der zweiten Schicht trennt,

wobei diese Vorrichtung **dadurch gekennzeichnet ist, dass** die Temperatur der Blockierung der Magnetisierung der Speicherschicht niedriger als die Temperatur der Blockierung der Magnetisierung der Bezugsschicht ist und dass die Vorrichtung außerdem umfasst:

- Mittel zum Erwärmen der Speicherschicht auf eine Temperatur, die höher als die Temperatur der Blockierung der Magnetisierung dieser Speicherschicht ist, wobei die Mittel zum Erwärmen der Speicherschicht Mittel (22, 24; 62, 60a, 60b, 60c, 60d; 76, 78; 104, 106; 124, 126) sind, die vorgesehen sind, um einen Elektronenstrom durch die magnetische Tunnelgrenzschicht fließen zu lassen, und
- Mittel zum Anlegen eines Magnetfelds (26, 64, 66, 68; 108; 116, 118) und/oder eines Magnetmoments (82, 90) an diese Speicherschicht, das in der Lage ist, die Magnetisierung dieser Speicherschicht bezüglich der Magnetisierung der Bezugsschicht auszurichten, ohne die Ausrichtung dieser Bezugsschicht zu ändern.

**2.** Vorrichtung nach Anspruch 1, bei der die Temperaturen der Blockierung der Speicher- und Bezugsschichten Werte haben, die höher als der Wert der Betriebstemperatur der Vorrichtung außerhalb der Erwärmung der Tunnelgrenzschicht ist.

**3.** Vorrichtung nach einem der Ansprüche 1 und 2, bei der die Magnetisierung jeder der Speicher- (38, 56, 86) und Bezugsschichten (36, 54, 83) im Wesentlichen senkrecht zu der Ebene dieser Schichten ist.

**4.** Vorrichtung nach Anspruch 3, bei der die Speicherschicht (38) eine Monoschicht aus einer Legierung Co-Pt oder Co-Pd oder eine Multischicht ist, die aus einem Stapel von Co-Schichten (44) gebildet ist, die mit Pt- oder Pd-Schichten (46) abwechseln, so dass das koerzitive Feld der Speicherschicht schnell abnimmt, wenn die Temperatur steigt.

5. Vorrichtung nach Anspruch 3, bei der die Speicherschicht eine Monoschicht aus einer an Kobalt reichen Legierung mit Eisen oder Nickel oder Chrom sowie Platin oder Palladium oder eine Multischicht ist, die von einem Stapel von Schichten aus einer an Kobalt reichen Legierung mit Eisen oder Nickel oder Chrom gebildet ist, die mit Pt- oder Pd-Schichten abwechseln, so dass das koerzitive Feld der Speicherschicht schnell abnimmt, wenn die Temperatur steigt.

6. Vorrichtung nach einem der Ansprüche 1 und 2, bei der die Magnetisierung jeder der Speicher- (20a, 98, 112) und Bezugsschichten (20c, 94, 114) im Wesentlichen zu der Ebene dieser Schichten parallel ist.

7. Vorrichtung nach einem der Ansprüche 1 bis 6, umfassend außerdem eine erste antiferromagnetische Schicht (50, 80, 96), die der Bezugsschicht zugeordnet ist.

8. Vorrichtung nach Anspruch 7, bei der die Temperatur der Blockierung der Magnetisierung dieser ersten antiferromagnetischen Schicht (50, 80, 96) höher als die Blockierungstemperatur der Speicherschicht ist.

9. Vorrichtung nach einem der Ansprüche 1 bis 8, bei der die Bezugsschicht eine Multischicht ist, die zwei magnetische Schichten und einen Zwischenschicht aus Ru oder aus Re oder aus Ir oder aus Rh umfasst, wobei die beiden magnetischen Schichten durch die Zwischenschicht getrennt und durch Interaktion über diese Zwischenschicht antiparallel gekoppelt sind.

10. Vorrichtung nach einem der Ansprüche 1 bis 9, umfassend außerdem eine zweite antiferromagnetische Schicht (100), die mit der Speicherschicht durch Austauschanisotropie gekoppelt ist.

11. Vorrichtung nach Anspruch 10, bei der die Temperatur der Blockierung der Magnetisierung dieser zweiten antiferromagnetischen Schicht (100) niedriger als die Blockierungstemperatur der Bezugsschicht ist.

12. Vorrichtung nach einem der Ansprüche 1 bis 10, **dadurch gekennzeichnet, dass** die Mittel zum Anlegen des Magnetfelds (26, 64, 66, 68; 108; 116, 118) mindestens eine leitende Strecke umfassen, die in der Lage ist, einen Stromimpuls zu tragen, um ein Magnetfeld in der Speicherschicht zu erzeugen.

13. Vorrichtung nach einem der Ansprüche 1 bis 12, bei der die Mittel zum Anlegen des Magnetmoments (82, 90) an die Speicherschicht (86) Mittel zum Einspritzen eines Stroms von Elektronen, deren Spin polarisiert ist, in diese Speicherschicht umfassen.

14. Vorrichtung nach Anspruch 13, **dadurch gekennzeichnet, dass** die Mittel zum Anlegen des Magnetmoments (82, 90) mindestens eine polarisierende Schicht umfassen, an die ein Stromimpuls angelegt wird, um Elektronen mit polarisiertem Spin zu erzeugen.

15. Speicher, umfassend eine Matrix von Speicherpunkten, die in Adressierzeilen und -spalten adressierbar sind, wobei dieser Speicher **dadurch gekennzeichnet ist, dass** jeder Speicherpunkt umfasst:

    - eine magnetische Vorrichtung (16) nach einem der Ansprüche 1 bis 14 und
    - ein Mittel (24) zur Stromumschaltung, das mit dieser magnetischen Vorrichtung in Reihe geschaltet ist,

    wobei jede magnetische Vorrichtung mit einer Adressierzeile (22) verbunden ist und jedes Umschaltmittel mit einer Adressierspalte (28) verbunden ist.

16. Verfahren zum Schreiben einer Information in eine magnetische Vorrichtung nach einem der Ansprüche 1 bis 14, bei dem

    - man die Speicherschicht (20a, 38, 56, 86, 98, 112) auf eine Temperatur erwärmt, die höher als die Temperatur der Blockierung der Magnetisierung dieser Speicherschicht ist, und
    - man während der Abkühlung der Speicherschicht an diese Speicherschicht ein Magnetfeld oder Magnetmoment anlegt, das in der Lage ist, die Magnetisierung dieser Speicherschicht bezüglich der Magnetisierung der Bezugsschicht (20c, 36, 54, 82, 94, 114) auszurichten, ohne die Ausrichtung dieser Bezugsschicht zu ändern.

**17.** Verfahren nach Anspruch 16, bei dem der von der Bezugsschicht gesehene Wert des während des Lesens angelegten Magnetfelds (34, 72, 110, 120) oder Magnetmoments kleiner als das Magnetfeld oder Magnetmoment ist, das für die Rückkehr der Magnetisierung der Bezugsschicht bei der von dieser Schicht während der Erwärmung der Sperrschicht erreichten maximalen Temperatur erforderlich ist.

**18.** Verfahren nach einem der Ansprüche 16 und 17, bei dem die Speicherschicht mit einer antiferromagnetischen Schicht (100) durch Austauschanisotropie gekoppelt ist und man die Speicherschicht und diese antiferromagnetische Schicht auf eine Temperatur erwärmt, die höher als die Temperaturen der Blockierung der Magnetisierung dieser Schichten ist, und man während der Abkühlung der antiferromagnetischen Schicht die Magnetisierung der Speicherschicht in einer beliebigen Richtung ausrichtet, die durch die Magnetisierungsrichtung des bei der Abkühlung angelegten Magnetfelds vordefiniert ist.

**19.** Verfahren zum Lesen einer Information, die in der magnetischen Vorrichtung nach einem der Ansprüche 1 bis 14 gespeichert ist, bei dem

- man den Wert des Widerstands der magnetischen Tunnelgrenzschicht (18; 52a, 52b, 52c, 52d; 74) bestimmt und
- man die Ausrichtung der Magnetisierung der Speicherschicht ausgehend von diesem Wert des Widerstands ableitet.

**FIG. 1A**

**FIG. 1B**

10 (22)

2 (18)

10

2 (18)

4 (24)

12 (26)

14 (28)

14

12

14

12

14

**FIG. 2**

30

22

18

20a

20b

16

20c

32

24

34

28

26

**FIG. 3**

FIG. 4

FIG. 5

FIG. 6

FIG. 9

FIG. 7

FIG. 8

110

108

104

102

98

94

106

# FIG. 10

116

120

124

112

123

114

118

126

122

# FIG. 11